# EUROPÄISCHE PATENTSCHRIFT

(11) **EP 4 109 114 B1**
(45) Veröffentlichungstag und Bekanntmachung des Hinweises auf die Patenterteilung: **13.11.2024**
(21) Anmeldenummer: 22178698.1
(22) Anmeldetag: 13.06.2022
(51) Int. Cl.: G01R 15/20

(54) **SENSOREINHEIT ZUR HOCHEMPFINDLICHEN MESSUNG VON STRÖMEN**
SENSOR UNIT FOR HIGHLY SENSITIVE MEASUREMENT OF CURRENTS
UNITÉ DE CAPTEUR DESTINÉE À LA MESURE HAUTEMENT SENSIBLE DES COURANTS

(30) Priorität: 22.06.2021 DE 102021116112
(43) Veröffentlichungstag der Anmeldung: 28.12.2022
(73) Patentinhaber: W & S Technik GmbH, 44575 Castrop-Rauxel (DE)
(72) Erfinder: Kühnhold, Dennis, 59192 Bergkamen (DE)
(74) Vertreter: Andrejewski - Honke Patent- und Rechtsanwälte Partnerschaft mbB

(56) Entgegenhaltungen:
- EP-A2- 1 772 737
- DE-U1- 202008 012 593
- DE-U1- 202012 103 071
- US-A1- 2007 090 825
- US-A1- 2010 231 198

## Beschreibung

Die Erfindung betrifft eine Sensoreinheit zur kontaktierungsfreien Messung von Strömen in Stromkabeln, insbesondere in Datenkabeln, wobei die Sensoreinheit ein Gehäuse und eine Kabelführung für ein Stromkabel aufweist, wobei die Kabelführung ausgebildet ist, das Stromkabel über einen Längenabschnitt des Stromkabels hinweg aufzunehmen, wobei die Sensoreinheit wenigstens einen ersten Magnetfeldsensor und einen zweiten Magnetfeldsensor umfasst. Die Erfindung betrifft auch eine Verwendung der Sensoreinheit sowie ein Verfahren zur Messung von Strömen mit dieser Sensoreinheit.

Eine derartige Sensoreinheit ist beispielsweise aus DE 20 2012 103 071 U1 bekannt. Die Sensoreinheit umfasst ein Gehäuse sowie eine darin angeordnete Kabelführung für ein Stromkabel. Die Kabelführung wird - neben Aussparungen im Gehäuse - durch zwei im Inneren des Gehäuses befindliche Halbschalen gebildet, welche zu einem Hohlzylinder zusammengesetzt sind und durch welchen das Stromkabel hindurchgeführt wird. Auf der Innenseite des Hohlzylinders sind zwei oder mehr Magnetfeldsensoren in Form von Hallsensoren angeordnet. Die Magnetfeldsensoren können gleichgerichtet oder in verschiedenen Winkelstellungen zur Längsachse des Stromkabels ausgerichtet sein.

Das Gehäuse aus DE 20 2012 103 071 U1 ist etwa quaderförmig ausgebildet, wobei das Stromkabel parallel zu einer Längsachse des Gehäuses geführt ist. Das Stromkabel tritt an einer ersten Stirnseite in das Gehäuse ein, um schließlich an der gegenüberliegenden Stirnseite wieder aus dem Gehäuse herausgeführt zu werden. Das Gehäuse umfasst eine obere und eine untere Schale, welche über Scharniere an der Längsseite des Gehäuses zueinander verschwenkbar sind. Die obere Schale und die untere Schale können auf der den Scharnieren gegenüberliegenden Längsseite mittels Bolzen verschlossen werden. Die Verschwenkbarkeit der Schalen ermöglicht eine Anordnung des Stromkabels innerhalb des Gehäuses, ohne dass ein offenes Ende des Stromkabels durch das Gehäuse geführt werden müsste.

Nachteilig an derartigen Sensoreinheiten ist jedoch, dass diese nur relativ geringe Messgenauigkeiten aufweisen. Diese können zwar im "Milli-Ampere-Bereich" Strom messen, doch sind damit im Wesentlichen Ströme unterhalb von 1A gemeint. Aus diesem Grunde sind die bekannten Sensoreinheiten im Wesentlichen dazu geeignet, die Ströme von Stromversorgungskabeln für Stromverbraucher zu messen.

Es wäre allerdings in vielen Bereichen sehr von Vorteil, nicht nur Stromversorgungskabel kontaktierungsfrei hinsichtlich der Stromstärke zu vermessen, sondern auch die in der Regel wesentlich dünneren elektrischen Datenkabel. Beispielsweise finden sich etliche Datenkabel in Relaisräumen von Stellwerken, die zumeist in Strömen abgebildete Signale führen. Strommessungen an diesen Datenkabeln würden eine Überwachung der durch die Datenkabel gesendeten elektrischen Signale ermöglichen. Im Falle von Stellwerken könnten die Sensoreinheiten in den Relaisräumen zum Beispiel dazu benutzt werden, eine etwaige Fehlbedienung durch das Bedienpersonal nachweisen zu können. Die meist binären und kurzzeitigen Stromsignale von elektrischen Datenkabeln allerdings weisen in der Regel eine Stromstärke von deutlich weniger als 100 mA auf, woran die bekannten Sensoreinheiten scheitern.

Der Erfindung liegt daher die technische Aufgabe zugrunde, eine Sensoreinheit zu schaffen, welche eine deutlich größere Messgenauigkeit als die bekannten Sensoreinheiten bietet, so dass insbesondere die Ströme von elektrischen Datenkabeln kontaktierungsfrei überwacht werden können.

Diese Aufgabe wird gelöst durch eine Sensoreinheit zur kontaktierungsfreien Messung von Strömen in Stromkabeln, insbesondere in Datenkabeln, wobei die Sensoreinheit ein Gehäuse und eine Kabelführung für ein Stromkabel aufweist, wobei die Kabelführung ausgebildet ist, das Stromkabel über einen Längenabschnitt des Stromkabels hinweg aufzunehmen, wobei die Sensoreinheit wenigstens einen ersten Magnetfeldsensor und einen zweiten Magnetfeldsensor umfasst, wobei die Kabelführung so ausgebildet ist, dass ein erstes Segment der Kabelführung einen ersten Teilabschnitt des Stromkabels mit einer ersten Längsrichtung des Stromkabels definiert und der erste Teilabschnitt des Stromkabels in einer Draufsicht der Sensoreinheit mit dem ersten Magnetfeldsensor überlappt, wobei die Kabelführung so ausgebildet ist, dass ein zweites Segment der Kabelführung einen zweiten Teilabschnitt des Stromkabels mit einer zweiten Längsrichtung des Stromkabels definiert und der zweite Teilabschnitt des Stromkabels in einer Draufsicht der Sensoreinheit mit dem zweiten Magnetfeldsensor überlappt, wobei die Kabelführung so ausgebildet ist, dass die zweite Längsrichtung des Stromkabels von der ersten Längsrichtung des Stromkabels abweicht.

Der Erfindung liegt zunächst die Erkenntnis zugrunde, dass die Vermessung von elektrischen Datenkabeln einer deutlich größeren Messgenauigkeit im Vergleich zu den bisher bekannten Sensoreinheiten bedarf. Für die erforderlichen Messgenauigkeiten ist bereits das Erdmagnetfeld ein störender Faktor. Ferner wurde gefunden, dass auch die dynamischen elektromagnetischen Störfelder, wie sie etwa in Relaisräumen und ganz allgemein in Räumen mit weiteren Stromkabeln auftreten, die Messergebnisse erheblich verfälschen. Die dynamischen Störfelder wie auch das statische Erdmagnetfeld tragen jeweils zum störenden Umgebungsmagnetfeld bei.

Der Erfindung liegt insbesondere die Erkenntnis zugrunde, dass deutlich präzisere Messungen erreicht werden, wenn das Stromkabel innerhalb der Sensoreinheit keinen rein geradlinigen Verlauf, sondern einen wenigstens stellenweise gebogenen Verlauf aufweist. So führt die unterschiedliche Führung der Längsrichtungen der beiden Teilabschnitte des Stromkabels dazu, dass das Umgebungsmagnetfeld besonders gut aus den Rohdaten der Magnetfeldsensoren herausgerechnet werden kann. Es wurde schließlich gefunden, dass eine Herausrechnung des Umgebungsmagnetfeldes schwerlich möglich ist, wenn das Stromkabel in der Sensoreinheit vollständig geradlinig geführt wird. Dies gilt auch dann, wenn die beiden Magnetfeldsensoren unterschiedliche Ausrichtungen aufweisen. Erfindungswesentlich ist es daher, dass die Kabelführung so ausgebildet sein muss, dass das Stromkabel in der Sensoreinheit seine Richtung ändert. Im Ergebnis ermöglicht die erfindungsgemäße Sensoreinheit sehr genaue Messwerte bis hinunter zu Strömen von 1 mA, so dass die eingangs genannte Aufgabe gelöst wird. Außerdem können erfindungsgemäße Sensoreinheiten Gleichströme und/oder Wechselströme erfassen. Somit eignen sich die erfindungsgemäßen Sensoreinheiten für nahezu alle industriellen Anwendungen, in denen sehr geringe Ströme kontaktierungsfrei zu messen sind.

Der Begriff "kontaktierungsfrei" meint vorzugsweise, dass für die Messung des Stroms in dem Stromkabel kein elektrischer Kontakt zwischen dem Stromkabel und der Sensoreinheit erforderlich ist. Es ist ganz besonders bevorzugt, dass die Sensoreinheit so ausgebildet ist, dass das Stromkabel lediglich in die Sensoreinheit eingelegt werden muss, so dass es insbesondere nicht erforderlich ist, ein offenes Ende des Stromkabels durch die Sensoreinheit zu führen. Der Begriff "Draufsicht" meint insbesondere die Sicht auf eine der beiden Seiten der Platine und bevorzugt auf diejenige der beiden Seiten der Platine, auf welcher die Magnetfeldsensoren angeordnet sind. Zweckmäßigerweise ist diejenige Seite der Platine, auf welcher die Magnetfeldsensoren befindlich sind, die Oberseite der Platine, wohingegen die von der Oberseite abgewandte Seite die Unterseite der Platine ist. Es ist bevorzugt, dass die Oberseite und die Unterseite der Platine die Richtungen "oben" sowie "unten" für die gesamte Sensoreinheit definieren. Vorzugsweise ist der Blick von oben auf die Oberseite der Platine die Draufsicht.

Es ist von Vorteil, dass das Gehäuse eine Eingangsöffnung und eine Ausgangsöffnung für das Stromkabel aufweist. Zweckmäßigerweise ist die Eingangsöffnung des Gehäuses einer Eingangsseite des Gehäuses und die Ausgangsöffnung einer Ausgangsseite des Gehäuses zugeordnet. Es ist insbesondere von Vorteil, dass die Eingangsseite einer Längsseite des Gehäuses entspricht. Die Begriffe "Eingang" und "Ausgang" beziehen sich vorzugsweise nicht auf die Stromrichtung, sondern dienen zweckmäßigerweise lediglich der begrifflichen Unterscheidung der entsprechenden Seiten des Gehäuses. Es ist möglich, dass die Ausgangsseite des Gehäuses einer Stirnseite des Gehäuses entspricht. Vorzugsweise umfasst die Sensoreinheit eine Anschlussleitung. Die Anschlussleitung kann ein Anschlusskabel und/oder ein Anschlusssteckelement, insbesondere einen Anschlussstecker bzw. eine Anschlussbuchse, aufweisen. Es ist bevorzugt, dass die Anschlussleitung bzw. das Anschlusskabel über eine Anschlussöffnung des Gehäuses in das Gehäuse eingeführt wird. Die Anschlussöffnung des Gehäuses ist bevorzugt Bestandteil einer Stirnseite des Gehäuses und weiter bevorzugt in einer der Ausgangsseite des Gehäuses gegenüberliegenden Stirnseite des Gehäuses angeordnet.

Es ist besonders bevorzugt, dass das Gehäuse ein Abschirmgehäuse aufweist, wobei das Abschirmgehäuse bevorzugt Metall, weiter bevorzugt Mu-Metall, umfasst. Es ist von Vorteil, dass die Platine in alle Raumrichtungen - zweckmäßigerweise mit Ausnahme der Eingangsöffnung bzw. -Öffnungen, der Ausgangsöffnung bzw. Ausgangsöffnungen und der Anschlussöffnung bzw. - Öffnungen - von dem Abschirmgehäuse umgeben ist. Das Abschirmgehäuse weist bevorzugt eine obere Schale und eine untere Schale auf. Zweckmäßigerweise lassen sich die obere Schale und die untere Schale in einer Richtung senkrecht zur Platine bzw. zu einer Oberseite der Magnetfeldsensoren ineinanderschieben. Es ist besonders bevorzugt, dass die obere Schale und die untere Schale beim Ineinanderschieben einen gleitenden Formschluss ausüben. Es ist besonders bevorzugt, dass beim Ineinanderschieben der oberen Schale und der unteren Schale keine Spannung in der oberen Schale und/oder der unteren Schale gespeichert wird. Es ist zweckmäßig, dass die obere Schale und/die untere Schale Seitenwände aufweisen. Mit Vorteil lässt sich eine der beiden Schalen vollständig in die jeweils andere Schale schieben. Es ist bevorzugt, dass eine Höhe der Seitenwände der oberen Schale identisch ist mit derjenigen der Seitenwände der unteren Schale. Es ist zweckmäßig, dass die obere Schale und/oder die untere Schale durchgängig eine Materialstärke aufweist/aufweisen. Zweckmäßigerweise besitzen die obere Schale und die untere Schale dieselbe Materialstärke.

Vorteilhafterweise umfasst das Abschirmgehäuse einen Verschlussmechanismus. Der Verschlussmechanismus kann, beispielsweise fensterartige, Verschlusselemente an der oberen Schale und/oder der unteren Schale umfassen. Es ist von Vorteil, dass der Verschlussmechanismus Ausnehmungen und vorzugsweise lediglich Ausnehmungen bzw. Öffnungen bzw. Durchbrüche aufweist. Es ist bevorzugt, dass die Verschlusselemente des Abschirmgehäuses mit Schließelementen eines/des Schutzgehäuses wechselwirken. Das Schutzgehäuse kann beispielsweise auf seiner Innenseite Schließelemente in Form von nach innen ragenden Vorsprüngen aufweisen. Das Abschirmgehäuse bzw. die obere Schale bzw. die untere Schale weist/weisen bevorzugt eine Eingangsöffnung und/oder eine Ausgangsöffnung für ein Stromkabel in einer Seitenwand auf. Die Eingangsöffnung bzw. Eingangsöffnungen sind bevorzugt einer Eingangsseite bzw. Längsseite der Sensoreinheit zugeordnet. Die Ausgangsöffnung bzw. Ausgangsöffnungen sind mit Vorteil einer Ausgangsseite bzw. einer Stirnseite der Sensoreinheit zugeordnet. Die Eingangsöffnung/Eingangsöffnungen bzw. die Ausgangsöffnung/ Ausgangsöffnungen sind vorteilhafterweise U-förmig ausgebildet. Es ist von Vorteil, dass das Abschirmgehäuse bzw. die obere Schale bzw. die untere Schale eine Anschlussöffnung für die Anschlussleitung aufweist/aufweisen. Die Anschlussöffnung der oberen Schale bzw. der unteren Schale ist mit Vorteil U-förmig ausgestaltet. Das Abschirmgehäuse umfasst besonders bevorzugt ein Sichtfenster. Das Sichtfenster ist vorzugsweise in einer Oberseite der oberen Schale angeordnet, wobei das Sichtfenster vorteilhafterweise eine Ausdehnung in eine Richtung von mehr als 10 mm nicht überschreitet.

Vorzugsweise umfasst die obere Schale wenigstens ein Betätigungselement und vorzugsweise zwei Betätigungselemente, welche beispielsweise als Aussparung bzw. Aussparungen ausgebildet ist/sind. Mit Vorteil ist das Betätigungselement bzw. sind die Betätigungselemente jeweils auf einer Längsseite bzw. in einer Längswand der oberen Schale angeordnet. Die Betätigungselemente sind bevorzugt als Aussparungen in den Seitenwänden der oberen Schale ausgestaltet, so dass die Seitenwände der unteren Schale gegriffen werden können und die obere und die untere Schale auseinanderziehbar sind.

Es ist sehr vorteilhaft, wenn das Gehäuse ein Schutzgehäuse aufweist, wobei das Schutzgehäuse vorzugsweise so ausgebildet ist, dass es in einer anderen Richtung als das Abschirmgehäuse geöffnet wird. Das Schutzgehäuse umfasst bevorzugt ein Hauptteil und ein Abschlussteil. Das Hauptteil ist vorzugsweise so ausgebildet, dass die Anschlussleitung bzw. das Anschlusselement durch eine Wand des Hauptteils, insbesondere durch eine Stirnwand des Hauptteils, hindurchführbar ist. Das Hauptteil ist besonders bevorzugt so ausgestaltet, dass es wenigstens abschnittsweise in wenigstens einer Ebene das Abschirmgehäuse vollständig bzw. um 360° umläuft. Es ist sehr bevorzugt, dass das Schutzgehäuse bzw. das Hauptteil des Schutzgehäuses auf das Abschirmgehäuse aufschiebbar, insbesondere mittels gleitendem Formschluss aufschiebbar ausgebildet ist. Es ist von Vorteil, dass das Hauptteil bzw. das Schutzgehäuse in einer Längsrichtung, insbesondere entlang der Längsseiten des Abschirmgehäuses, auf das Abschirmgehäuse aufschiebbar ist. Der vollständige Umlauf des Schutzgehäuses verhindert vorzugsweise ein Öffnen des Abschirmgehäuses solange, bis das Schutzgehäuse vom Abschirmgehäuse abgezogen ist.

Mit Vorteil weist das Hauptteil Schließelemente auf, welche das Hauptteil bzw. das Schutzgehäuse auf dem Abschirmgehäuse bzw. auf der oberen und/oder unteren Schale des Abschirmgehäuses fixieren und insbesondere einrasten lässt. Die Schließelemente des Hauptteils bzw. Schutzgehäuses korrespondieren bevorzugt mit Verschlusselementen bzw. einem Verschlussmechanismus des Abschirmgehäuses bzw. der oberen Schale bzw. der unteren Schale. Das Abschlussteil des Schutzgehäuses umfasst bevorzugt eine Stirnwand des Schutzgehäuses, welche vorteilhafterweise der Stirnwand mit der Anschlussöffnung des Schutzgehäuses gegenüberliegt. Das Abschlussteil umfasst bevorzugt Schließelemente, insbesondere nach innen ragende Vorsprünge, welche mit den Verschlusselementen - insbesondere mit Ausnehmungen bzw. fensterartigen Öffnungen - der oberen und/oder unteren Schale korrespondieren.

Es ist bevorzugt, dass das Schutzgehäuse bzw. das Abschlussteil eine Eingangsöffnung und/oder eine Ausgangsöffnung für das Stromkabel aufweist. Die Eingangsöffnung und/oder die Ausgangsöffnung des Schutzgehäuses bzw. des Hauptteils ist/sind vorzugsweise U-förmig ausgestaltet. Es ist von Vorteil, dass das Schutzgehäuse bzw. das Hauptteil bzw. das Abschlussteil Kunststoff umfasst bzw. aus Kunststoff besteht. Es ist besonders bevorzugt, dass das Schutzgehäuse das Abschirmgehäuse wenigstens abschnittsweise und vorzugsweise wenigstens zu 50 % bzw. 70 % bzw. 90 % bzw. 95 % bzw. 99 % der Oberfläche des Abschirmgehäuses bedeckt.

Vorzugsweise ist das Abschlussteil in einer Draufsicht U-förmig ausgestaltet. Es ist sehr bevorzugt, dass die Form des Abschlussteils komplementär zu der Form des Hauptteils ist, so dass sich das Abschlussteil und das Hauptteil, insbesondere zu einem Quader, ergänzen. Es ist von Vorteil, dass das Schutzgehäuse bzw. das Hauptteil ein Sichtfenster aufweist, welches Sichtfenster vorzugsweise mit dem Sichtfenster des Abschirmgehäuses bzw. des Innengehäuses korrespondiert. Vorzugsweise korrespondiert die Anschlussöffnung des Schutzgehäuses mit der Anschlussöffnung bzw. den Anschlussöffnungen des Abschirmgehäuses bzw. des Innengehäuses. Zweckmäßigerweise korrespondieren die Eingangsöffnung bzw. die Ausgangsöffnung des Schutzgehäuses mit der Eingangsöffnung bzw. den Eingangsöffnungen bzw. der Ausgangsöffnung bzw. den Ausgangsöffnungen des Abschirmgehäuses.

Gemäß einer besonders bevorzugten Ausführungsform umfasst das Gehäuse ein Innengehäuse, wobei das Innengehäuse vorzugsweise Kunststoff aufweist und insbesondere aus Kunststoff besteht. Das Innengehäuse ist bevorzugt zwischen der Platine und dem Abschirmgehäuse angeordnet. Es ist sehr von Vorteil, dass das Innengehäuse eine/die Platine, insbesondere die Platine mit den Magnetfeldsensoren, umschließt. Das Innengehäuse weist bevorzugt ein Oberteil und ein Unterteil auf. Die Oberseite der Platine mit den Magnetfeldsensoren ist zweckmäßigerweise der Oberseite des Innengehäuses zugewandt.

Es ist ganz besonders bevorzugt, dass das Innengehäuse bzw. das Oberteil die Kabelführung aufweist. Zweckmäßigerweise umfasst das Innengehäuse bzw. das Oberteil bzw. das Unterteil eine Anschlussöffnung für die Anschlussleitung bzw. das Anschlusskabel. Die Anschlussöffnung des Innengehäuses ist mit Vorteil so ausgebildet, dass sie einen Kraftschluss auf das Anschlusskabel ausbildet und eine Zugsicherung darstellt. Mit Vorteil umfasst das Unterteil Seitenwände. Die Seitenwände des Unterteils nehmen vorzugsweise die Platine zwischen sich auf.

Es ist bevorzugt, dass das das Innengehäuse bzw. das Oberteil ein Sichtfenster aufweist, welches Sichtfenster bevorzugt mit dem Sichtfenster des Abschirmgehäuses und/oder des Schutzgehäuses korrespondiert. Es ist bevorzugt, dass das Oberteil ein Zugriffsfenster aufweist, welches einen Zugriff auf elektrische Zugriffskontakte der Platine bietet. Die elektrischen Zugriffskontakte dienen bevorzugt der Programmierung einer/der Recheneinheit der Platine bzw. der Sensoreinheit.

Zweckmäßigerweise umfasst das Innengehäuse bzw. das Oberteil bzw. die Kabelführung eine Eingangsaussparung und/oder eine Ausgangsaussparung. Es ist bevorzugt, dass die Eingangsaussparung und/oder die Ausgangsaussparung gegenüber Seitenwänden des Oberteils bzw. des Innengehäuses vorstehen. Hierdurch wird insbesondere erreicht, dass das Stromkabel vor den Kanten des Abschirmgehäuses, insbesondere der unteren Schale, geschützt wird. Die Sensoreinheit ist bevorzugt so ausgestaltet, dass die Sensoreinheit ab Werk und damit im Einsatz nicht mehr bis auf die Platine geöffnet werden muss. Stattdessen reicht es, das Schutzgehäuse und das Abschirmgehäuse zu öffnen, um dann das Stromkabel in die Kabelführung einzulegen, um daraufhin das Abschirmgehäuse und das Schutzgehäuse wieder zu schließen. Aufgrund des Zugriffsfensters ist es selbst in Fällen einer späteren Wartung oder Softwareaktualisierung nicht mehr erforderlich, das Innengehäuse zu öffnen, so dass eine besonders große Langlebigkeit erzielt wird.

Es ist sehr bevorzugt, dass die Kabelführung bzw. die Sensoreinheit so ausgebildet ist, dass das Stromkabel derart in die Kabelführung einbringbar ist, dass das Stromkabel an den Magnetfeldsensoren anliegt. Hierdurch wird erreicht, dass weitere Millimeter oder sogar Zehntel Millimeter Distanz zwischen dem Stromkabel und den Magnetfeldsensoren vermieden werden. So können dass die Magnetfeldsensoren die größtmöglichen Werte des Magnetfeldes erfassen, wodurch die Messgenauigkeit gesteigert wird. Es ist sehr bevorzugt, dass die Kabelführung wenigstens einen Durchbruch aufweist, wobei von Vorteil ist, dass die Kabelführung zwei Durchbrüche bzw. einen ersten Durchbruch und einen zweiten Durchbruch aufweist. Zweckmäßigerweise ist dem ersten Segment der Kabelführung der erste Durchbruch und dem zweiten Segment der zweite Durchbruch zugeordnet. Der Durchbruch bzw. die Durchbrüche sind vorzugsweise so ausgebildet, dass sie die Magnetfeldsensoren wenigstens teilweise in sich aufnehmen können. Vorteilhafterweise bilden die Magnetfeldsensoren abschnittsweise jeweils einen Boden der Kabelführung aus. Es ist insbesondere vorteilhaft, wenn das Innengehäuse bzw. das Oberteil des Innengehäuses den Durchbruch bzw. die Durchbrüche aufweist. Gemäß einer bevorzugten Ausführungsform nehmen die Durchbrüche jeweils einen Magnetfeldsensor formschlüssig in x- und/oder in y-Richtung auf. Es ist bevorzugt, dass in einer Draufsicht der erste Magnetfeldsensor mit dem ersten Durchbruch wenigstens teilweise überlappt. Vorteilhafterweise überlappt in einer Draufsicht der zweite Magnetfeldsensor mit dem zweiten Durchbruch wenigstens teilweise und bevorzugt vollständig.

Es ist insbesondere von Vorteil, dass die Kabelführung wenigstens abschnittsweise im Querschnitt und vorzugsweise vollständig entlang ihrer Ausdehnung nach oben offen, beispielsweise U-förmig oder C-förmig, ausgebildet ist. Die Kabelführung ist mit Vorteil Bestandteil des Innengehäuses bzw. des Oberteils des Innengehäuses. Die Kabelführung ist vorzugsweise auf einer Außenseite, insbesondere auf einer Oberseite des Innengehäuses bzw. des Oberteils des Innengehäuses angeordnet. Gemäß einer bevorzugten Ausführungsform umfasst die Kabelführung eine Krümmung zwischen dem ersten Segment und dem zweiten Segment. Hierdurch wird eine definierte Biegung des Stromkabels erreicht. Die Krümmung mag einen Radius von wenigstens 2 mm und vorzugsweise von wenigstens 3 mm aufweisen.

Gemäß einer ganz besonders bevorzugten Ausführungsform sind das erste Segment und das zweite Segment der Kabelführung zueinander rechtwinklig ausgerichtet. Gemäß einer bevorzugten Ausführungsform sind das erste Segment und das zweite Segment der Kabelführung in einer Draufsicht so ausgebildet, dass die erste Längsrichtung des Stromkabels um wenigstens 70° bzw. 80° und vorzugsweise um wenigstens 85° und besonders vorzugsweise um wenigstens 88° zur zweiten Längsrichtung des Stromkabels gewinkelt ist. Es ist bevorzugt, dass das erste Segment und das zweite Segment der Kabelführung so ausgebildet sind, dass die erste Längsrichtung des Stromkabels um höchstens 110° bzw. 100° bzw. 95° bzw. 92° zur zweiten Längsrichtung des Stromkabels gewinkelt ist. Zweckmäßigerweise liegt das Stromkabel bzw. die Kabelführung in einer Draufsicht im Überlappungsbereich mit den Magnetfeldsensoren in einer Ebene, wobei diese Ebene bevorzugt zu der Oberseite der Platine ausgerichtet ist. Es ist von Vorteil, dass die Kabelführung so ausgebildet ist, dass das Stromkabel in einer Draufsicht und im Überlapp mit den Magnetfeldsensoren geradlinig verläuft, wobei insbesondere der erste Teilabschnitt und der zweite Teilabschnitt geradlinig ausgerichtet sind.

Es ist von besonderem Vorteil, wenn eine Unterseite des ersten Magnetfeldsensors und eine Unterseite des zweiten Magnetfeldsensors zueinander parallel ausgerichtet sind und vorzugsweise auf einer gemeinsamen Ebene angeordnet sind. So ermöglicht eine präzise Ausrichtung der Magnetfeldsensoren entsprechend präzise Messungen. Gemäß einer besonders bevorzugten Ausführungsform sind die Unterseite des ersten Magnetfeldsensors und die Unterseite des zweiten Magnetfeldsensors auf einer Oberfläche, insbesondere auf der Oberseite der Platine angeordnet. Zweckmäßigerweise sind der erste Magnetfeldsensor und der zweite Magnetfeldsensor auf einer Oberfläche der Platine angeordnet, welche dem Stromkabel bzw. der Kabelführung zugewandt ist. Es ist ganz besonders bevorzugt, dass der erste Magnetfeldsensor und der zweite Magnetfeldsensor das Magnetfeld in wenigstens zwei und vorzugsweise in drei Raumdimensionen erfassen können. Vorteilhafterweise sind die Magnetfeldsensoren magnetoresistiv. Bevorzugt weisen die Magnetfeldsensoren einen Messbereich von wenigstens +/- 2 Gs bzw. +/- 4 Gs bzw. +/- 6 Gs auf. Mit Vorteil weisen die Magnetfeldsensoren ein Rauschen mit einem quadratischen Mittelwert von höchstens 5 mGs bzw. 2 mGs bzw. 1 mGs bzw. 0,6 mGs auf. Besonders vorzugsweise sind der erste Magnetfeldsensor und der zweite Magnetfeldsensor baugleich. Es ist besonders bevorzugt, dass die beiden Magnetfeldsensoren über voneinander getrennte Schnittstellen mit der Recheneinheit verbunden sind.

Gemäß einer ganz besonders bevorzugten Ausführungsform sind x-Achsen der Magnetfeldsensoren in einer Draufsicht um höchstens 20° bzw. 10° bzw. 5° und vorzugsweise um höchstens 2° zueinander gewinkelt. Es ist besonders bevorzugt, dass x-Achsen der Magnetfeldsensoren in einer Draufsicht parallel zueinander ausgerichtet sind. Es ist sehr von Vorteil, dass die Kabelführung so ausgebildet ist, dass das Stromkabel in einer Draufsicht um höchstens 20° bzw. 10° bzw. 5° von einer x-Achse von einem der beiden Magnetfeldsensoren und/oder um höchstens 20° bzw. 10° bzw. 5° von der y-Achse des anderen der beiden Magnetfeldsensoren abweicht. Gemäß einer ganz besonders bevorzugten Ausführungsform ist die Kabelführung so ausgestaltet, dass das Stromkabel in einer Draufsicht parallel zu einer x-Achse von einem der beiden Magnetfeldsensoren und parallel zur y-Achse des anderen der beiden Magnetfeldsensoren ausgerichtet ist.

Mit Vorteil umfasst die Sensoreinheit eine Anschlussleitung. Die Anschlussleitung weist bevorzugt ein Anschlusskabel und/oder ein Anschlusssteckelement auf. Das Anschlusssteckelement mag beispielsweise ein Anschlussstecker oder eine Anschlussbuchse sein. Es ist möglich, dass die Anschlussleitung mehrere bzw. wenigstens vier bzw. sechs bzw. acht Adern aufweist. Zweckmäßigerweise dienen zwei Adern der Stromversorgung der Sensoreinheit. Es ist möglich, dass insgesamt vier Kommunikationsadern für die Kommunikation vorgesehen sind. Beispielsweise können jeweils zwei Adern der vier Kommunikationsadern für ein Kommunikationsprotokoll vorgesehen werden. Mit Vorteil sind zwei Adern für einen CAN-Bus vorgesehen. Zwei Adern können für eine GPIO-Kommunikation bestimmt sein. Es ist möglich, dass eine Ader für eine Status-LED vorgesehen ist. Eine Ader ist vorzugsweise für ein Ausschalten der Kommunikation vorgesehen. Das Anschlusssteckelement bzw. der Anschlussstecker mag die äußerlichen Abmessungen eines Ethernet-Steckelements bzw. -steckers aufweisen.

Es ist zweckmäßig, dass die Sensoreinheit eine Platine und/oder einen Prozessor aufweist. Mit Vorteil sind die Magnetfeldsensoren auf der Platine angeordnet. Die Platine umfasst zweckmäßigerweise wenigstens eine Lichtquelle, insbesondere wenigstens eine LED. Es ist bevorzugt, dass die wenigstens eine Lichtquelle mit dem Sichtfenster des Innengehäuses bzw. Abschirmgehäuses bzw. Schutzgehäuses korrespondiert. Mit Vorteil umfasst die Platine Zugriffsanschlüsse bzw. Zugriffskontakte, mit welchen ein Zugriff auf die Recheneinheit - insbesondere ein programmierender Zugriff - auf die Recheneinheit ermöglicht wird. Hierdurch werden unnötige Adern in der Anschlussleitung bzw. im Anschlusskabel vermieden.

Die eingangs genannte Aufgabe wird gelöst durch ein Verfahren zur kontaktierungsfreien Messung von Strömen in Stromkabeln, insbesondere in Datenkabeln, mit einer Sensoreinheit, insbesondere mit einer erfindungsgemäßen Sensoreinheit, wobei die Sensoreinheit ein Gehäuse und eine Kabelführung für ein Stromkabel aufweist, wobei die Kabelführung das Stromkabel über einen Längenabschnitt des Stromkabels hinweg aufnimmt, wobei die Sensoreinheit wenigstens einen ersten Magnetfeldsensor und einen zweiten Magnetfeldsensor umfasst, wobei ein erstes Segment der Kabelführung einen ersten Teilabschnitt des Stromkabels mit einer ersten Längsrichtung des Stromkabels definiert und der erste Teilabschnitt des Stromkabels in einer Draufsicht der Sensoreinheit mit dem ersten Magnetfeldsensor überlappt, wobei die Kabelführung so ausgebildet ist, dass ein zweites Segment der Kabelführung einen zweiten Teilabschnitt des Stromkabels mit einer zweiten Längsrichtung des Stromkabels definiert und der zweite Teilabschnitt des Stromkabels in einer Draufsicht der Sensoreinheit mit dem zweiten Magnetfeldsensor überlappt, wobei die zweite Längsrichtung des Stromkabels von der ersten Längsrichtung des Stromkabels abweicht.

Gemäß einer sehr bevorzugten Ausführungsform erfasst die Sensoreinheit eine Dauer eines Stromflusses in dem Stromkabel. Es ist von Vorteil, wenn die Sensoreinheit wenigstens zwei, vorzugsweise wenigstens drei bzw. vier Messpunkte einer Serie in einem definierten Zeitraum erfasst. Der definierte Zeitraum beträgt vorzugsweise wenigstens 1 ms bzw. 2 ms bzw. 5 ms je Messpunkt. Mit Vorteil beläuft sich der definierte Zeitraum je Messpunkt auf höchstens 100 ms bzw. 50 ms bzw. 20 ms. Es ist sehr bevorzugt, dass der Wert des Magnetfeldes lediglich dann erfasst wird, wenn bei allen Messpunkten einer Serie der Wert des Magnetfeldes oberhalb eines eingestellten Schwellwertes liegt. Der eingestellte Schwellwert mag beispielsweise dem Doppelten des quadratischen Mittelwerts des Rauschens entsprechen. Mit Vorteil ist die Sensoreinheit so ausgebildet, dass sie eine Tastenstörung meldet, wenn ein Stromfluss von mehr als 2 s bzw. 3 s Dauer gemessen wird.

Nachfolgend wird ein erfindungsgemäßes Ausführungsbeispiel anhand von vier schematischen Figuren erläutert. Es zeigen
- Fig. 1: eine erste perspektivische Ansicht einer an einem Stromkabel montierten Sensoreinheit,
- Fig. 2: eine zweite perspektivische Ansicht der Sensoreinheit aus Fig. 1 in einer Explosionsdarstellung,
- Fig. 3: eine dritte perspektivische Ansicht der Sensoreinheit aus den Fig. 1 und 2 in einer Explosionsdarstellung und
- Fig. 4: eine stark vereinfachte Draufsicht auf die Sensoreinheit der Fig. 1 bis 3.

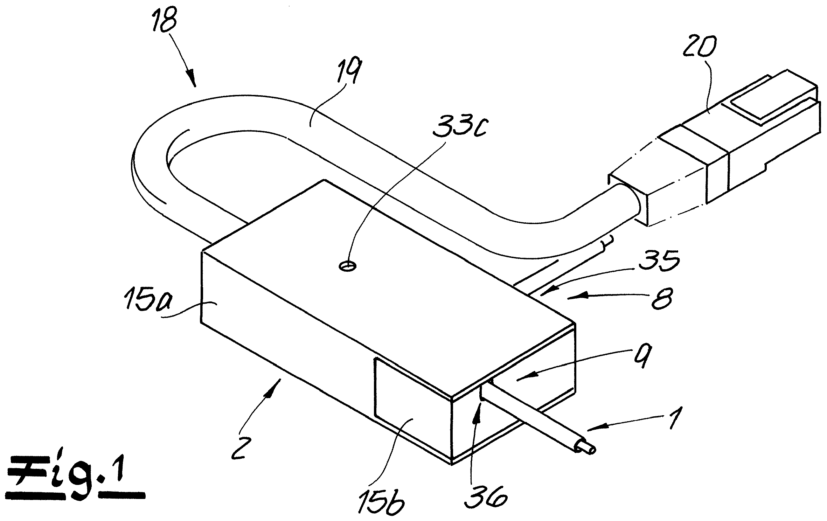

In Fig. 1 ist das erfindungsgemäße Ausführungsbeispiel der Sensoreinheit an einem zu vermessenden Stromkabel 1 montiert. Die Sensoreinheit umfasst ein Gehäuse 2 mit einem weiter unten detailliert beschriebenen Innenleben sowie vorzugsweise eine Anschlussleitung 18. Mit Vorteil ist das Gehäuse 2 mehrschichtig und insbesondere dreischichtig ausgebildet, so dass in Fig. 1 lediglich ein Schutzgehäuse 15a, 15b des Gehäuses 2 erkennbar ist. Das Schutzgehäuse 15a, 15b umfasst vorzugsweise ein Hauptteil 15a sowie ein Abschlussteil 15b. Es ist bevorzugt, dass das Stromkabel 1 durch das Abschlussteil 15b geführt wird.

In diesem Ausführungsbeispiel ist eine Längsseite des Gehäuses 2, welche dem Anschlussstecker 20 in Fig. 1 zugewandt ist, als Eingangsseite 8 definiert, während die Stirnseite, an welcher das Stromkabel 1 aus dem Gehäuse 2 austritt, als Ausgangsseite 9 bestimmt ist. Zweckmäßigerweise besitzt das Gehäuse 2 an der Eingangsseite 8 eine Eingangsöffnung 35 sowie eine Ausgangsöffnung 36 an der Ausgangsseite 9. In Fig. 1 ist schließlich erkennbar, dass das Gehäuse 2 ein kleines Sichtfenster 33c aufweist, welches vorzugsweise der Erkennung des Status der Sensoreinheit anhand von im Inneren befindlichen LEDs dient.

Die Anschlussleitung 18 dieses Ausführungsbeispiels umfasst ein Anschlusskabel 19 sowie einen Anschlussstecker 20. Der Anschlussstecker 20 entspricht von seinen äußerlichen Abmessungen her bevorzugt einem Ethernet-Stecker, besitzt jedoch eine gänzlich andere Verschaltung, so dass der Anschlussstecker 20 nur in räumlicher, nicht aber in elektrischer Hinsicht mit anderen Ethernet-Komponenten kompatibel ist. Die Anschlussleitung 18 kann insbesondere mit einem speziell auf die Anschlussleitung 18 angepassten und hier nicht dargestellten Verteilerknoten angeschlossen werden, so dass eine Vielzahl von Sensoreinheiten, überwacht bzw. gesteuert werden kann.

In diesem Ausführungsbeispiel befindet sich die dargestellte Sensoreinheit mit vielen anderen, gleichartig aufgebauten Sensoreinheiten in einem Relaisraum eines Stellwerkes, um die dortigen Stromkabel 1 in Form von elektrischen Datenkabel zu überwachen. Die Überwachung der Datenkabel dient insbesondere dazu, Fehlsignale aufzuspüren. Die Fehlsignale können beispielsweise von elektrischen Defekten oder aber von einer Fehlbedienung durch das Bedienpersonal herrühren.

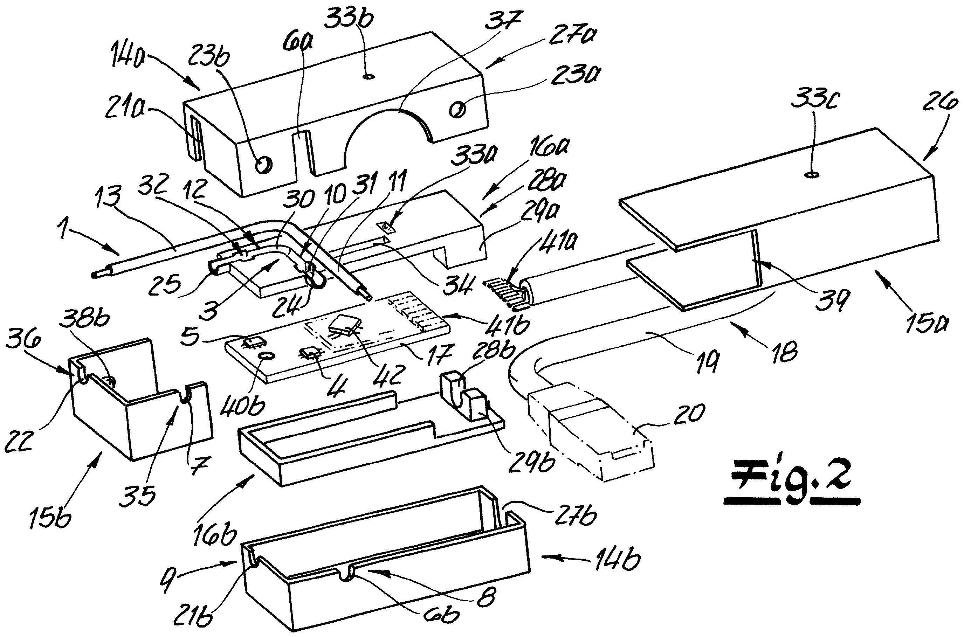

In Fig. 2 ist die Sensoreinheit aus Fig. 1 in einer Explosionsdarstellung und aus einer anderen Perspektive abgebildet. Das in diesem Fall dreischichtig ausgeführte Gehäuse 2 umfasst neben dem bereits beschriebenen Schutzgehäuse 15a, 15b ein Abschirmgehäuse 14a, 14b mit einer oberen Schale 14a und einer unteren Schale 14b. Das Gehäuse 2 umfasst bevorzugt ein Innengehäuse 16a, 16b, welches vorzugsweise ein Oberteil 16a und ein Unterteil 16b umfasst. Das Innengehäuse 16a, 16b umschließt in diesem Ausführungsbeispiel eine Platine 17, welche über elektrische Kontakte 41a, 41b mit der Anschlussleitung 18 verbunden ist. Die elektrischen Kontakte 41a, 41b weisen zweckmäßigerweise Aderenden 41 der Anschlussleitung 18 bzw. des Anschlusskabels 19 sowie dazugehörige Lötplätze 41b auf der Platine 17 auf. Die Zahl der Adern der Anschlussleitung 18 sowie der dazugehörigen Kontakte 41a, 41b mag beispielsweise acht betragen. Auf der Platine 17 sind ein erster Magnetfeldsensor 4 und ein zweiter Magnetfeldsensor 5 sowie vorzugsweise eine Recheneinheit 42 angeordnet.

Das Unterteil 16b weist bevorzugt Seitenwände auf, welche die Platine 17 formschlüssig aufnehmen. Es ist von Vorteil, dass das Unterteil 16b eine Anschlussöffnung 28b aufweist, welche das Anschlusskabel 19 formschlüssig und besonders bevorzugt auch kraftschlüssig im Zusammenspiel mit einer Anschlussöffnung 28a des Oberteils 16a aufnimmt, wodurch eine Zugsicherung entsteht. Die Anschlussöffnung 28b wird vorzugsweise von Befestigungselementen 29b des Unterteils 16b umschlossen, welche in korrespondierende Befestigungsteile 29a des Oberteils 16a eingreifen. Vorteilhafterweise fixieren die Befestigungselemente 29b im Zusammenspiel mit den Seitenwänden des Unterteils 16b die Platine 17 formschlüssig, so dass die Platine 17 im Verhältnis zum Innengehäuse 16a, 16b exakt positionierbar ist.

Die Sensoreinheit umfasst eine Kabelführung 3, welche das Stromkabel 1 innerhalb der Sensoreinheit entlang einer definierten Bahn positioniert. Es ist sehr bevorzugt, dass die Kabelführung 3 Bestandteil des Innengehäuses 16a, 16b und insbesondere des Oberteils 16a ist. Die Kabelführung 3 umfasst ein erstes Segment 10, welches einen ersten Teilabschnitt 11 des Stromkabels 1 aufnimmt. Die Kabelführung 3 umfasst ferner ein zweites Segment 12, welches einen zweiten Teilabschnitt 13 des Stromkabels 1 aufnimmt. Zweckmäßigerweise umfasst die Kabelführung 3 einen gekrümmten Abschnitt 30, welcher das erste Segment 10 mit dem zweiten Segment 12 verbindet. Besonders vorzugsweise sind das erste Segment 10 bzw. der erste Teilabschnitt 11 und das zweite Segment 12 bzw. der zweite Teilabschnitt 13 zueinander um 90° gewinkelt. Es ist bevorzugt, dass der Verlauf des Stromkabels 1 innerhalb der Sensoreinheit in einer Ebene parallel zur Platine 17 verläuft.

Die Kabelführung 3 bzw. das erste Segment 10 weist bevorzugt einen ersten Durchbruch 31 auf, so dass der erste Magnetfeldsensor 4 mit Vorteil einen Boden der Kabelführung 3 bildet. Die Kabelführung 3 bzw. das zweite Segment 12 weist bevorzugt einen zweiten Durchbruch 32 auf, so dass mit Vorteil der zweite Magnetfeldsensor 5 einen Boden der Kabelführung 3 bzw. des zweiten Segments 12 bildet. Hierdurch wird erreicht, dass die beiden Magnetfeldsensoren 4, 5 möglichst nah an das Stromkabel 1 heranreichen und idealerweise an diesem anliegen. Vorzugsweise ist die Kabelführung 3 im Querschnitt U-förmig ausgebildet. Die Kabelführung 3 weist zweckmäßigerweise eine Eingangsaussparung 24 und eine Ausgangsaussparung 25 auf, welche der Eingangsseite 8 bzw. der Ausgangsseite 9 zugeordnet sind.

Das Innengehäuse 16a, 16b und insbesondere das Oberteil 16a umfasst vorzugsweise ein Zugriffsfenster 34, welches einen elektrischen Zugriff auf weitere elektrische Kontakte der Platine 17 bietet, ohne dass das Innengehäuse 16a, 16b geöffnet werden müsste. Das Zugriffsfenster 34 mag insbesondere der Programmierung der Recheneinheit 42 dienen. Es bevorzugt, dass das Innengehäuse 16a, 16b und insbesondere das Oberteil 16a ein Sichtfenster 33a aufweist. Das Sichtfenster 33a mag beispielsweise durch einen transparenten Kunststoffkörper verschlossen sein und vorzugsweise mit entsprechenden Öffnungen 33b, 33c der oberen Schale 14a bzw. des Hauptteils 15a korrespondieren. Vorzugsweise umfasst die Platine LEDs, insbesondere Status-LEDs, welche durch das Sichtfenster 33a, 33b, 33c sichtbar sind. Das Innengehäuse 16a, 16b bzw. das Oberteil 16a und/oder das Unterteil 16b umfassen bevorzugt Kunststoff bzw. sind vollständig aus Kunststoff hergestellt.

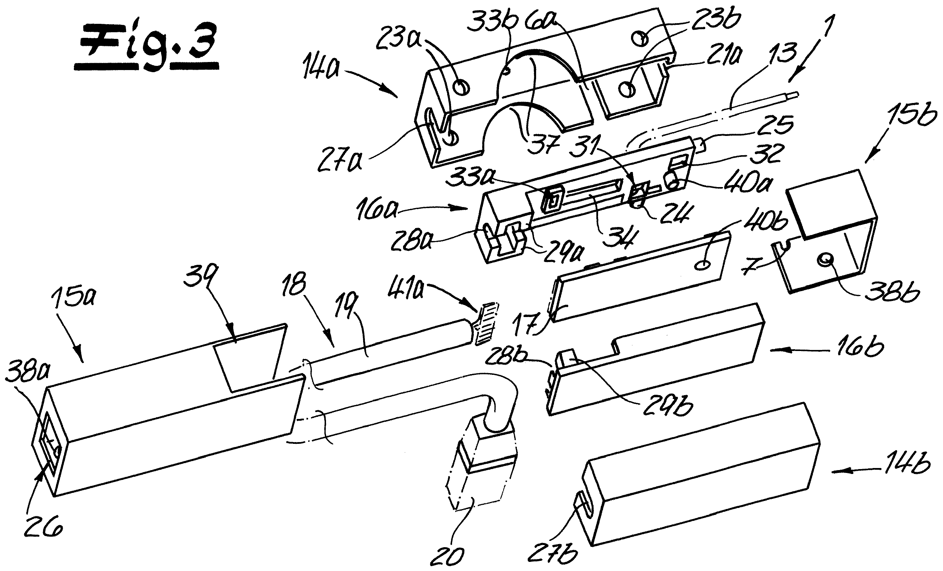

Es ist sehr bevorzugt, dass das Abschirmgehäuse 14a, 14b bzw. die obere Schale 14a und/oder die untere Schale 14b Metall, insbesondere Mu-Metall umfasst. Die untere Schale 14b weist bevorzugt eine Anschlussöffnung 27b auf, welche zweckmäßigerweise mit einer Anschlussöffnung 27a aus Fig. 3 der oberen Schale 14a korrespondiert. Vorzugsweise umfasst die untere Schale 14b eine Eingangsöffnung 6b für das Stromkabel 1, welche vorteilhafterweise U-förmig ausgebildet ist und zweckmäßigerweise mit einer Eingangsöffnung 6a der oberen Schale 14a korrespondiert. Mit Vorteil umfasst die untere Schale 14b eine Ausgangsöffnung 21b, welche zweckmäßigerweise mit einer Ausgangsöffnung 21a der oberen Schale 14a korrespondiert. Es ist sehr bevorzugt, dass die untere Schale 14b und die obere Schale 14a in einer Richtung senkrecht zur Oberfläche der Platine 17 übereinander geschoben werden können, um das Innengehäuse 16a, 16b einzuschließen. Mit Vorteil umschließt die obere Schale 14a die untere Schale 14b. Es ist bevorzugt, dass die Eingangsaussparung 24 und/oder die Ausgangsaussparung 25 gegenüber der Längsseite bzw. der Stirnseite des Oberteils 16a vorkragen, so dass das Stromkabel 1 vor den Kanten der Eingangsöffnung 6b bzw. der Ausgangsöffnung 21b der unteren Schale 14b geschützt ist/sind. Es bevorzugt, dass die obere Schale 14a Betätigungselemente 37 in Form von Aussparungen an den Seitenwänden, bevorzugt an den Seitenwänden der Längsseiten, aufweist. Hierdurch können die obere Schale 14a und die untere Schale 14b leichter auseinandergezogen werden.

Es ist von Vorteil, dass das Abschirmgehäuse 14a, 14b Verschlusselemente 23a, 23b aufweist. Die Verschlusselemente 23b können insbesondere als Fenster ausgestaltet sein, in welche nach innen ragende Schließelemente 38b des Abschlussteils 15b eingreifen und einrasten können. Dabei schließt das Abschlussteil 15b eine Ausnehmung 39 des Hauptteils 15a, wodurch die Quaderform des Schutzgehäuses 15a, 15b komplettiert wird. Das Abschlussteil 15b weist zweckmäßigerweise eine Eingangsöffnung 7 und/oder eine Ausgangsöffnung 22 auf, welche bevorzugt U-förmig ausgestaltet sind. Die U-förmige Gestaltung der Elemente 7, 22 führt dazu, dass das Stromkabel 1 bei der Montage der Sensoreinheit einfach eingelegt werden kann und nicht etwa ein offenes Ende des Stromkabels 1 durch umlaufende Löcher hindurchgeführt werden muss.

Die perspektivische Ansicht der Fig. 3 erlaubt einen Blick auf die Unterseite der Sensoreinheit bzw. der verschiedenen Komponenten der Sensoreinheit. Zweckmäßigerweise umfasst das Hauptteil 15a des Schutzgehäuses 15a, 15b eine Anschlussöffnung 26 zum Hindurchführen der Anschlussleitung 18 bzw. des Anschlusssteckers 20, so dass das Hauptteil 15a in Längsrichtung des zweiten Teilabschnitts 13 auf das Abschirmgehäuse 14a, 14b aufgeschoben wird. Hierdurch werden die obere Schale 14a und die untere Schale 14b zusammengehalten. Das Hauptteil 15a umfasst auf seiner Innenseite bevorzugt zwei einander gegenüberliegende Schließelemente 38a, welche beim Aufschieben des Hauptteils 15a auf das Abschirmgehäuse 14a, 14b in Eingriff mit den beiden Verschlusselementen 23a der oberen Schale 14a gebracht werden, wodurch das Hauptteil 15a mit der oberen Schale 14a verrastet.

Die Sensoreinheit bzw. das Aggregat aus Platine 17 und Innengehäuse 16a, 16b umfasst vorzugsweise eine Fixierung 40a, 40b, wobei mit Vorteil ein Fixierungsteil 40a des Oberteils 16a in Eingriff mit einem Fixierungselement 40b der Platine gebracht wird. Die Perspektive der Fig. 3 gibt außerdem einen Blick auf eine Unterseite der Befestigungsteile 29a des Oberteils 16a frei, in welche die Befestigungselemente 29b des Unterteils 16b eingreifen.

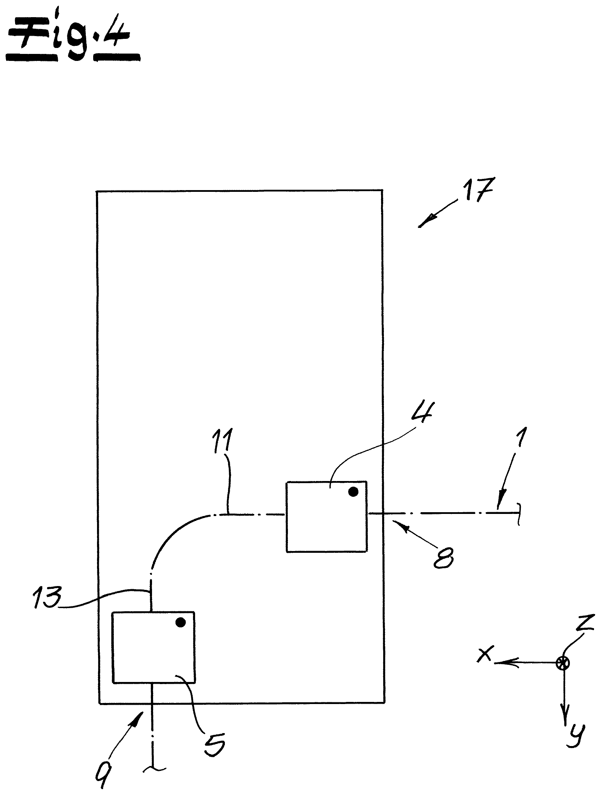

In Fig. 4 schließlich ist die Sensoreinheit bzw. die Platine 17 stark vereinfacht wiedergegeben, wobei außerdem das Oberteil 16a der Einfachheit halber weggelassen wurde. Es ist ganz besonders bevorzugt, dass die beiden Magnetfeldsensoren 4, 5 auf der Platine 17 dieselbe Ausrichtung aufweisen, was in Fig. 4 über jeweils einen schwarzen Punkt auf den Magnetfeldsensoren 4, 5 symbolisiert wird. In diesem Ausführungsbeispiel erfassen die Magnetfeldsensoren 4, 5 das Magnetfeld in alle drei Raumrichtungen x, y, z. Die Raumrichtung z ist zweckmäßigerweise senkrecht zu einer Oberfläche der Platine 17 definiert. Es ist besonders vorteilhaft, wenn das Stromkabel 1 in der Kabelführung 3 so geführt ist, dass der erste Teilabschnitt 11 und der zweite Teilabschnitt 13 zueinander einen rechten Winkel in einer Draufsicht auf die Platine 17 ausbilden. Vorzugsweise überlappt das Stromkabel 1 in einer Draufsicht mit dem ersten Magnetfeldsensor 4 und/oder mit dem zweiten Magnetfeldsensor 5. Es ist sehr bevorzugt, dass das Stromkabel 1 parallel zu einer x-Achse von einem der beiden Magnetfeldsensoren 4, 5 verläuft und/oder parallel zu der y-Achse des anderen der beiden Magnetfeldsensoren 4, 5 verläuft.

Stromdurchflossene Leiter bilden gemäß Rechte-Faust-Regel Magnetfelder aus. Da das Stromkabel 1 auf den Magnetfeldsensoren 4, 5 aufliegt, liegen die Magnetfeldsensoren 4, 5 nicht konzentrisch im jeweiligen Magnetfeld des Stromkabels 1. Deshalb erfassen beide Magnetfeldsensoren 4, 5 jeweils eine z-Komponente sowie eine transversale Komponente (y-Komponente im Falle des ersten Teilabschnitts 11 bzw. x-Komponente im Falle des zweiten Teilabschnitts 13). Jede der beiden Komponenten ist proportional zum Stromfluss innerhalb des Stromkabels 1, so dass bereits über die Erfassung von einer der beiden Komponenten der Stromfluss in dem Stromkabel 1 bestimmt werden kann.

Im Falle von Magnetfeldsensoren für die Erfassung der Magnetfelder in alle drei Raumrichtungen ergibt sich bei Verwendung von zwei Magnetfeldsensoren ein Gleichungssystem aus insgesamt sechs Gleichungen. Nach Vereinfachung und entsprechender Umrechnung kann die transversale Komponente des Magnetfeldes des Stromkabels per Subtraktion der beiden y-Komponenten oder der beiden x-Komponenten der beiden Magnetfeldsensoren bestimmt werden.

Würde hingegen eine völlig geradlinig verlaufende Kabelführung verwendet, so wäre die Verwendung von zwei gleich ausgerichteten Magnetfeldsensoren sinnlos, weil dann ein- und dieselbe Messung lediglich wiederholt würde und die transversale Komponente deshalb nicht ermittelt werden könnte. Auch die Rotation der Ausrichtung von einem der beiden Magnetfeldsensoren um 90° auf der Platine führt nicht dazu, dass das Gleichungssystem sich dergestalt vereinfacht, dass am Ende die transversale Komponente oder die z-Komponente des Magnetfeldes von einem der beiden Teilabschnitte 11, 13 bestimmt werden könnte. Aus diesem Grunde ist die Änderung der Längsrichtung des Stromkabels 1 innerhalb der Sensoreinheit erfindungswesentlich.

### Übersicht der Bezugszeichen:

| **B.Z** | **Bezeichnung** | **B.Z** | **Bezeichnung** |
|---|---|---|---|
| 1 | Stromkabel | 20 | Anschlussstecker |
| 2 | Gehäuse | 21a, b | Ausgangsöffnung von 14a, b |
| 3 | Kabelführung | 22 | Ausgangsöffnung von 15b |
| 4 | erster Magnetfeldsensor | 23a, b | Verschlusselemente von 14a |
| 5 | zweiter Magnetfeldsensor | 24 | Eingangsaussparung von 3, 16a |
| 6a, b | Eingangsöffnung von 14a, b | 25 | Ausgangsaussparung von 3, 16a |
| 7 | Eingangsöffnung von 15b | 26 | Anschlussöffnung von 15a |
| 8 | Eingangsseite | 27a, b | Anschlussöffnung von 14a, b |
| 9 | Ausgangsseite | 28a, b | Anschlussöffnung von 16a, b |
| 10 | erstes Segment | 29a, b | Befestigung: |
| | | | Befestigungsteil 29a |
| | | | Befestigungselement 29b |
| 11 | erster Teilabschnitt | 30 | gekrümmter Abschnitt |
| 12 | zweites Segment | 31 | Durchbruch von 10 |
| 13 | zweiter Teilabschnitt | 32 | Durchbruch von 12 |
| 14a, b | Abschirmgehäuse: | 33a, b, c | Sichtfenster von 16a, 14a, 15a |
| | obere Schale 14a | | |
| | untere Schale 14b | | |
| 15a, b | Schutzgehäuse: | 34 | Zugriffsfenster von 16a |
| | Hauptteil 15a | | |
| | Abschlussteil 15b | | |
| 16a, b | Innengehäuse: | 35 | Eingangsöffnung von 2 |
| | Oberteil 16a | | |
| | Unterteil 16b | | |
| 17 | Platine | 36 | Ausgangsöffnung von 2 |
| 18 | Anschlussleitung | 37 | Betätigungselement |
| 19 | Anschlusskabel | 38a, b | Schließelemente von 15a, 15b |
| 39 | Ausnehmung von 15a | | |
| 40a, b | Fixierung: | | |
| | Fixierungsteil 40a | | |
| | Fixierungselement 40b | | |
| 41a, b | elektrische Kontakte: | | |
| | Aderenden 41a | | |
| | Lötplätze 41b | | |
| 42 | Recheneinheit | | |

## Patentansprüche

1. Sensoreinheit zur kontaktierungsfreien Messung von Strömen in Stromkabeln (1), insbesondere in Datenkabeln, wobei die Sensoreinheit ein Gehäuse (2) und eine Kabelführung (3) für ein Stromkabel (1) aufweist, wobei die Kabelführung (3) ausgebildet ist, das Stromkabel (1) über einen Längenabschnitt des Stromkabels (1) hinweg aufzunehmen, wobei die Sensoreinheit wenigstens einen ersten Magnetfeldsensor (4) und einen zweiten Magnetfeldsensor (5) umfasst,
wobei die Kabelführung (3) so ausgebildet ist, dass ein erstes Segment (10) der Kabelführung (3) einen ersten Teilabschnitt (11) des Stromkabels (1) mit einer ersten Längsrichtung des Stromkabels (1) definiert und der erste Teilabschnitt (11) des Stromkabels (1) in einer Draufsicht der Sensoreinheit mit dem ersten Magnetfeldsensor (4) überlappt, wobei die Kabelführung (3) so ausgebildet ist, dass ein zweites Segment (12) der Kabelführung (3) einen zweiten Teilabschnitt (13) des Stromkabels (1) mit einer zweiten Längsrichtung des Stromkabels (1) definiert,
**dadurch gekennzeichnet, dass**
der zweite Teilabschnitt (13) des Stromkabels (1) in einer Draufsicht der Sensoreinheit mit dem zweiten Magnetfeldsensor (5) überlappt, wobei die Kabelführung (3) so ausgebildet ist, dass die zweite Längsrichtung des Stromkabels (1) von der ersten Längsrichtung des Stromkabels (1) abweicht.

2. Sensoreinheit nach Anspruch 1, wobei das Gehäuse (2) ein Abschirmgehäuse (14a, 14b) aufweist, wobei das Abschirmgehäuse (14a, 14b) bevorzugt Metall, weiter bevorzugt Mu-Metall, umfasst.

3. Sensoreinheit nach Anspruch 1 oder 2, wobei das Gehäuse (2) ein Schutzgehäuse (15a, 15b) aufweist, wobei das Schutzgehäuse (15a, 15b) vorzugsweise so ausgebildet ist, dass es in einer anderen Richtung als das Abschirmgehäuse (14a, 14b) geöffnet wird.

4. Sensoreinheit nach einem der Ansprüche 1 bis 3, wobei das Gehäuse (2) ein Innengehäuse (16a, 16b) aufweist, wobei das Innengehäuse (16a, 16b) vorzugsweise Kunststoff umfasst.

5. Sensoreinheit nach einem der Ansprüche 1 bis 4, wobei die Kabelführung (3) bzw. die Sensoreinheit so ausgebildet ist, dass das Stromkabel (1) derart in die Kabelführung (3) einbringbar ist, dass das Stromkabel (1) an den Magnetfeldsensoren (4, 5) anliegt.

6. Sensoreinheit nach einem der Ansprüche 1 bis 5, wobei das erste Segment (10) und das zweite Segment (12) der Kabelführung (3) so ausgebildet sind, dass die erste Längsrichtung des Stromkabels (1) um wenigstens 80° und vorzugsweise um wenigstens 85° zur zweiten Längsrichtung des Stromkabels gewinkelt ist.

7. Sensoreinheit nach einem der Ansprüche 1 bis 6, wobei eine Unterseite des ersten Magnetfeldsensors (4) und eine Unterseite des zweiten Magnetfeldsensors (5) zueinander parallel ausgerichtet sind und vorzugsweise auf einer gemeinsamen Ebene angeordnet sind.

8. Sensoreinheit nach einem der Ansprüche 1 bis 7, wobei x-Achsen der Magnetfeldsensoren (4, 5) in einer Draufsicht um höchstens 5° bzw. 2° zueinander gewinkelt sind.

9. Sensoreinheit nach einem der Ansprüche 1 bis 8, wobei die Sensoreinheit eine Platine (17) aufweist, wobei bevorzugt ist, dass die Magnetfeldsensoren (4, 5) auf der Platine (17) angeordnet sind.

10. Verfahren zur kontaktierungsfreien Messung von Strömen in Stromkabeln, insbesondere in Datenkabeln, mit einer Sensoreinheit, insbesondere mit einer Sensoreinheit gemäß einem der Ansprüche 1 bis 8, wobei die Sensoreinheit ein Gehäuse (2) und eine Kabelführung (3) für ein Stromkabel (1) aufweist, wobei die Kabelführung (3) das Stromkabel (1) über einen Längenabschnitt des Stromkabels (1) hinweg aufnimmt, wobei die Sensoreinheit wenigstens einen ersten Magnetfeldsensor (4) und einen zweiten Magnetfeldsensor (5) umfasst,
wobei ein erstes Segment (10) der Kabelführung (3) einen ersten Teilabschnitt (11) des Stromkabels (1) mit einer ersten Längsrichtung des Stromkabels (1) definiert und der erste Teilabschnitt (11) des Stromkabels (1) in einer Draufsicht der Sensoreinheit mit dem ersten Magnetfeldsensor (4) überlappt, wobei ein zweites Segment (12) der Kabelführung (3) einen zweiten Teilabschnitt (13) des Stromkabels (1) mit einer zweiten Längsrichtung des Stromkabels (1) definiert,
**dadurch gekennzeichnet, dass**
der zweite Teilabschnitt (13) des Stromkabels (1) in einer Draufsicht der Sensoreinheit mit dem zweiten Magnetfeldsensor (5) überlappt, wobei die zweite Längsrichtung des Stromkabels (1) von der ersten Längsrichtung des Stromkabels (1) abweicht.

## Claims

1. Sensor unit for contactless measurement of currents in power cables (1), in particular in data cables, wherein the sensor unit comprises a housing (2) and a cable guide (3) for a power cable (1), the cable guide (3) being designed to receive the power cable (1) over a length section of the power cable (1), and the sensor unit comprises at least one first magnetic field sensor (4) and a second magnetic field sensor (5),
wherein the cable guide (3) is designed such that a first segment (10) of the cable guide (3) defines a first portion (11) of the power cable (1) with a first longitudinal direction of the power cable (1) and the first portion (11) of the power cable (1) overlaps with the first magnetic field sensor (4) in a plan view of the sensor unit, wherein the cable guide (3) is designed such that a second segment (12) of the cable guide (3) defines a second portion (13) of the power cable (1) with a second longitudinal direction of the power cable (1),
**characterized in that**
the second portion (13) of the power cable (1) overlaps with the second magnetic field sensor (5) in a plan view of the sensor unit, wherein the cable guide (3) is designed such that the second longitudinal direction of the power cable (1) deviates from the first longitudinal direction of the power cable (1).

2. Sensor unit according to Claim 1, wherein the housing (2) has a shielding housing (14a, 14b), the shielding housing (14a, 14b) preferably comprising metal, more preferably mu-metal.

3. Sensor unit according to Claim 1 or 2, wherein the housing (2) has a protective housing (15a, 15b), the protective housing (15a, 15b) being preferably designed such that it is opened in a different direction than the shielding housing (14a, 14b).

4. Sensor unit according to any one of Claims 1 to 3, wherein the housing (2) has an inner housing (16a, 16b), the inner housing (16a, 16b) preferably comprising plastic.

5. Sensor unit according to any one of Claims 1 to 4, wherein the cable guide (3) and/or the sensor unit is designed such that the power cable (1) can be inserted into the cable guide (3) in such a manner that the power cable (1) abuts against the magnetic field sensors (4, 5) .

6. Sensor unit according to any one of Claims 1 to 5, wherein the first segment (10) and the second segment (12) of the cable guide (3) are designed such that the first longitudinal direction of the power cable (1) is angled by at least 80° and preferably by at least 85° with respect to the second longitudinal direction of the power cable.

7. Sensor unit according to any one of Claims 1 to 6, wherein an underside of the first magnetic field sensor (4) and an underside of the second magnetic field sensor (5) are oriented parallel to each other and preferably arranged on a common plane.

8. Sensor unit according to any one of Claims 1 to 7, wherein x-axes of the magnetic field sensors (4, 5) in a plan view are angled by a maximum of 5° or 2° with respect to each other.

9. Sensor unit according to any one of Claims 1 to 8, wherein the sensor unit has a circuit board (17), the magnetic field sensors (4, 5) being preferably arranged on the circuit board (17).

10. Method for contactless measurement of currents in power cables, in particular in data cables, having a sensor unit, in particular a sensor unit according to any one of Claims 1 to 8, wherein the sensor unit comprises a housing (2) and a cable guide (3) for a power cable (1), wherein the cable guide (3) receives the power cable (1) over a length section of the power cable (1), and the sensor unit comprises at least one first magnetic field sensor (4) and a second magnetic field sensor (5),
wherein a first segment (10) of the cable guide (3) defines a first portion (11) of the power cable (1) with a first longitudinal direction of the power cable (1) and the first portion (11) of the power cable (1) overlaps with the first magnetic field sensor (4) in a plan view of the sensor unit, wherein a second segment (12) of the cable guide (3) defines a second portion (13) of the power cable (1) with a second longitudinal direction of the power cable (1),
**characterized in that**
the second portion (13) of the power cable (1) overlaps with the second magnetic field sensor (5) in a plan view of the sensor unit, wherein the second longitudinal direction of the power cable (1) deviates from the first longitudinal direction of the power cable (1).

## Revendications

1. Unité de capteur pour la mesure sans contact de courants dans des câbles d'alimentation (1), en particulier dans des câbles de données, dans laquelle l'unité de capteur présente un boîtier (2) et un guide-câble (3) pour un câble d'alimentation (1), dans laquelle le guide-câble (3) est conçu pour former le câble d'alimentation (1) sur une longueur du câble d'alimentation (1), dans laquelle l'unité de capteur comprend au moins un premier capteur de champ magnétique (4) et un deuxième capteur de champ magnétique (5),
dans laquelle le guide-câble (3) est conçu de telle sorte qu'un premier segment (10) du guide-câble (3) définisse une première section partielle (11) du câble d'alimentation (1) avec une première direction longitudinale du câble d'alimentation (1) et la première section partielle (11) du câble d'alimentation (1), dans une vue de dessus chevauche l'unité de capteur avec le premier capteur de champ magnétique (4), dans laquelle le guide-câble (3) est conçu de telle sorte qu'un deuxième segment (12) du guide-câble (3) définisse une deuxième section partielle (13) du câble d'alimentation (1) avec une deuxième direction longitudinale du câble d'alimentation (1),
**caractérisée en ce que**
la deuxième section partielle (13) du câble d'alimentation (1) en vue de dessus chevauche l'unité de capteur avec le deuxième capteur de champ magnétique (5), dans laquelle le guide-câble (3) est conçu de telle sorte que la deuxième direction longitudinale du câble d'alimentation (1) s'écarte de la première direction longitudinale du câble d'alimentation (1).

2. Unité de capteur selon la revendication 1, dans laquelle le boîtier (2) présente un boîtier de blindage (14a, 14b), dans laquelle le boîtier de blindage (14a, 14b) comprend de préférence du métal, plus préférablement du métal MU.

3. Unité de capteur selon la revendication 1 ou 2, dans laquelle le boîtier (2) présente un boîtier de protection (15a, 15b), dans laquelle le boîtier de protection (15a, 15b) est de préférence conçu de manière à être ouvert dans une direction différente de celle du boîtier de blindage (14a, 14b).

4. Unité de capteur selon une des revendications 1 à 3, dans laquelle le boîtier (2) présente un boîtier interne (16a, 16b), dans laquelle le boîtier interne (16a, 16b) comprend de préférence du plastique.

5. Unité de capteur selon une des revendications 1 à 4, dans laquelle le guide-câble (3) ou l'unité de capteur est conçu de telle sorte que le câble d'alimentation (1) puisse être inséré dans le guide-câble (3) de telle manière que le câble d'alimentation (1) soit connecté aux capteurs de champ magnétique (4, 5).

6. Unité de capteur selon une des revendications 1 à 5, dans laquelle le premier segment (10) et le deuxième segment (12) du guide-câble (3) sont conçus de telle sorte que la première direction longitudinale du câble d'alimentation (1) soit inclinée d'au moins 80° et soit de préférence incliné d'au moins 85° par rapport à la deuxième direction longitudinale du câble d'alimentation.

7. Unité de capteur selon une des revendications 1 à 6, dans laquelle un côté inférieur du premier capteur de champ magnétique (4) et un côté inférieur du deuxième capteur de champ magnétique (5) sont alignés parallèlement l'un à l'autre et sont de préférence disposés sur un plan commun.

8. Unité de capteur selon une des revendications 1 à 7, dans laquelle les axes x des capteurs de champ magnétique (4, 5) sont inclinés l'un par rapport à l'autre d'au plus 5° ou 2° dans une vue en plan.

9. Unité de capteur selon une des revendications 1 à 8, dans laquelle l'unité de capteur comporte une carte de circuit imprimé (17), dans laquelle il est préférable que les capteurs de champ magnétique (4, 5) soient disposés sur la carte de circuit imprimé (17).

10. Procédé de mesure sans contact de courants dans des câbles d'alimentation, en particulier dans des câbles de données, comportant une unité de capteur, en particulier comportant une unité de capteur selon une des revendications 1 à 8, dans lequel l'unité de capteur présente un boîtier (2) et un guide-câble (3) pour un câble d'alimentation (1), dans lequel le guide-câble (3) renferme le câble d'alimentation (1) sur une section de longueur du câble d'alimentation (1), dans lequel l'unité de capteur comprend au moins un premier un capteur de champ magnétique (4) et un deuxième capteur de champ magnétique (5),
dans lequel un premier segment (10) du guide-câble (3) définit une première section partielle (11) du câble d'alimentation (1) avec une première direction longitudinale du câble d'alimentation (1) et la première section partielle (11) du câble d'alimentation (1), dans une vue en plan, chevauche l'unité de capteur avec le premier capteur de champ magnétique (4), dans lequel un deuxième segment (12) du guide-câble (3) définit une deuxième section partielle (13) du câble d'alimentation (1) avec une deuxième direction longitudinale du câble d'alimentation (1),
**caractérisée en ce que**
la deuxième section partielle (13) du câble d'alimentation (1) chevauche dans une vue de dessus l'unité de capteur avec le deuxième capteur de champ magnétique (5), dans lequel la deuxième direction longitudinale du câble d'alimentation (1) s'écarte de la première direction longitudinale du câble d'alimentation (1).
